# EUROPÄISCHE PATENTSCHRIFT

(11) **EP 0 653 830 B1**
(45) Veröffentlichungstag und Bekanntmachung des Hinweises auf die Patenterteilung: **18.12.1996**
(21) Anmeldenummer: 94202809.3
(22) Anmeldetag: 29.09.1994
(51) Int. Cl.: H02M 1/088

(54) **Stromrichterschaltungsanordnung und Verfahren zur Ansteuerung derselben**
Arrangement of current rectifier circuit and controlling method
Disposition de circuit à redresseur de courant et méthode pour le commander

(30) Priorität: 21.10.1993 DE 4335857
(43) Veröffentlichungstag der Anmeldung: 17.05.1995
(73) Patentinhaber: ABB Management AG, 5401 Baden (CH)
(72) Erfinder: Gerster, Christian, CH-8037 Zürich (CH); Schöb, Reto, CH-8604 Hegnau (CH)
(74) Vertreter: Lück, Gert, Dr.

(56) Entgegenhaltungen:
- EP-A- 0 271 687

## Beschreibung

Die Erfindung bezieht sich auf das Gebiet der Leistungselektronik.

Sie geht aus von einem Verfahren zur Ansteuerung einer Stromrichterschaltungsanordnung nach dem Oberbegriff des ersten Anspruchs. Im weiteren betrifft sie eine Stromrichterschaltungsanordnung.

### Stand der Technik

Ein solches Verfahren bzw. eine Stromrichterschaltungsanordnung wird zum Beispiel schon im Artikel von A. Stamberger "Serie- oder parallelgeschaltete HochleistungsGTOs mit genau synchronisierter Abschaltung", Elektroniker Nr.3/1985, Seiten 68-72 beschrieben.

Wenn die einzelnen Zweige z.B. einer Halbbrücke seriegeschaltete Leistungshalbleiterschalter (im o.g. Artikel GTOs) enthalten, kann dies zu einer schlechten, d.h. ungleichmässigen Spannungsverteilung führen. Dies kann im weiteren zur Überbeanspruchung einzelner Halbleiter der Serieschaltung führen. Die Gründe dieser ungleichen Belastung liegen in unterschiedlichen Abschaltzeitpunkten, Parameter-Unterschieden der Halbleiter und der zugehörigen Beschaltungen sowie Parameter-Änderungen im Betrieb.

Im o.g. Artikel wird nun versucht die Spannungsbelastung der einzelnen Schalter auszugleichen, indem die Abschaltzeitpunkte der Steuersignale so geregelt werden, dass alle GTOs eines Stromrichterzweigs gleichzeitig zu sperren anfangen. Als Regelgrösse wird der Zeitpunkt des Abschaltsignals verwendet.

Damit wird aber nur der Abschaltzeitpunkt exakt ausgeregelt. Unregelmässige Spannungsbelastungen aufgrund von Parameter-Unterschieden und Parameter-Änderungen können jedoch nicht ausgeglichen werden, da über die exakte Spannungsverteilung keine Aussage gemacht werden kann. Darüberhinaus greift das vorne erläuterte Verfahren nur beim Schalten, genauer beim Abschalten ein. Spannungsmässige Belastungsunterschiede im stationären Zustand "Sperren" bleiben unbeachtet, obwohl diese aufgrund von Parameter-Unterschieden und -Drift auch auftreten können.

Demzufolge ist die Korrektur unvollständig und die Ausnützung der Halbleiter nicht optimal. Bei Anwendungen in grösseren Halbleitermodulen (0.5 MVA Schaltleistung und mehr) kann dies ungünstige Auswirkungen haben.

### Darstellung der Erfindung

Aufgabe der vorliegenden Erfindung ist es deshalb, ein Verfahren zur Ansteuerung einer Stromrichterschaltungsanordnung und eine Stromrichterschaltungsanordnung anzugeben, bei welchen die o.g. Nachteile des Standes der Technik vermieden werden sollen. Insbesondere soll die Regelung der Spannungsverteilung auch Parameter-Unterschiede und Änderungen berücksichtigen und auch im stationären Zustand zum Zuge kommen.

Diese Aufgabe wird bei einem Verfahren der eingangs genannten Art durch die Merkmale des ersten Anspruchs, bei einer Schaltungsanordnung der eingangs genannten Art durch die Merkmale des siebten Anspruchs gelöst.

Kern des erfindungsgemässen Verfahrens ist es also, dass als Regelgrösse die Spannung über jedem Schalter der Serieschaltung gemessen wird, aus dieser gemessenen Spannung die Schaltzeitpunkte so verändert werden, dass die spannungsmässige Belastung beim Schalten für alle Schalter im wesentlichen gleich gross wird, und anhand der gemessenen Spannung die Höhe der Steuerspannung im sperrenden Zustand so beeinflusst wird, dass die Sperrspannungen der Schalter im wesentlichen gleich gross sind.

Ein bevorzugtes Ausführungsbeispiel zeichnet sich dadurch aus, dass in einem bestimmten Schaltvorgang aus den gemessenen Schalterspannung und dem n-ten (bei n in Serie geschalteten Schaltern) der über der Serieschaltung total gemessenen Spannung je eine Differenz gebildet wird, in der Zeit zwischen zwei Schaltvorgängen aus dieser Differenz eine Vergrösserung bzw. Verkleinerung der Schaltzeitpunkt-Verzögerung für den nächsten Schaltvorgang berechnet wird und die derart bestimmten Schaltzeitpunkte im darauffolgenden Schaltvorgang eingestellt werden.

Beim Einschalten erhält man eine geringere Spannungsbelastung, falls früher eingeschaltet wird, eine grössere bei späterem Einschalten. Beim Ausschalten verhält es sich genau umgekehrt.

Im stationären, d.h. sperrenden Zustand kann der Sperrstrom mittels der Höhe des Steuersignals, d.h. der Abschalt-Gatespannung nahe an der Schwellspannung des Halbleiters gezielt vergrössert werden. Dadurch kann die Sperrspannung des einzelnen Halbleiters eingestellt werden. Ein Vergrösserung des Sperrstroms ergibt dabei ein Abnahme der Sperrspannung. Mit dieser Methode kann die Spannungsbelastung auch im sperrenden Zustand ausgeglichen werden.

Weitere Ausführungsbeispiele für das Verfahren ergeben sich aus den entsprechenden Unteransprüchen.

Der Kern der erfindungsgemässen Schaltungsanordnung besteht darin, dass in der Ansteuereinheit erste Mittel vorgesehen sind, welche über jedem Schalter eine Spannung messen, aus den gemessenen Spannungen und dem n-ten Teil der Gesamtspannung eine Differenz bilden und die Ein- und Ausschaltzeiten der Steuersignale jedes Schalters derart bestimmen, dass alle Schalter spannungsmässig gleich belastet sind. Zudem sind zweite Mittel vorgesehen, welche aus der berechneten Differenz die Höhe des Steuersignals im sperrenden Zustand derart einstellen, dass für alle Schalter eine gleiche Spannungsbelastung resultiert.

Diese ersten und zweiten Mittel können für jeden Schalter lokal oder für alle Schalter zusammen zentral vorgesehen sein.

Der Vorteil des erfindungsgemässen Verfahrens bzw. der Schaltungsanordnung besteht insgesamt darin, dass die Spannungsbelastung der einzelnen Halbleiter nicht nur beim Ein- und Ausschalten, sondern auch im sperrenden Zustand ausgeglichen werden kann. Zudem gleicht die Regelung auch Einflüsse von Parameter-Unterschieden und Änderungen sowie von Beschaltungs-Einflüssen aus. Dadurch können die Schalter sowohl leistungs- wie frequenzmässig optimal ausgenützt werden.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine Stromrichterschaltungsanordnung mit in Serie geschalteten Leistungshalbleitern;
- **Fig. 2**: Das Prinzipschaltbild einer erfindungsgemässen Ansteuereinheit für einen Schalter, welche beim Schalten die Spannungsbelastung der Schalter ausgleicht;
- **Fig. 3**: Das Prinzipschaltbild einer erfindungsgemässen Ansteuereinheit für einen Schalter, welche beim Sperren die Spannungsbelastung der Schalter ausgleicht;
- **Fig. 4**: Das Blockschaltbild der Ansteuereinheit für mehrere Schalter nach einem ersten Ausführungsbeispiel;
- **Fig. 5**: Das Blockschaltbild der Ansteuereinheit für mehrere Schalter nach einem zweiten Ausführungsbeispiel;
- **Fig. 6**: Die verschiedenen Phasen, Zustände und Spannungsbelastungen beim Schaltvorgang dreier Schalter;
- **Fig. 7**: Eine Darstellung wie die Spannungen über den Schaltern durch Verschiebung der Ein- bzw. Ausschaltzeitpunkte beeinflusst werden können;
- **Fig. 8**: Das Prinzip der Ausgleichsregelung beim Einschalten;
- **Fig. 9**: Das Prinzip der Ausgleichsregelung beim Ausschalten;
- **Fig. 10**: Das Prinzip der Ausgleichsregelung beim Sperren; und
- **Fig.11a-d**: Gemessene Spannungsverläufe von drei Schaltern beim Ein- und Ausschalten mit und ohne erfindungsgemässe Regelung.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

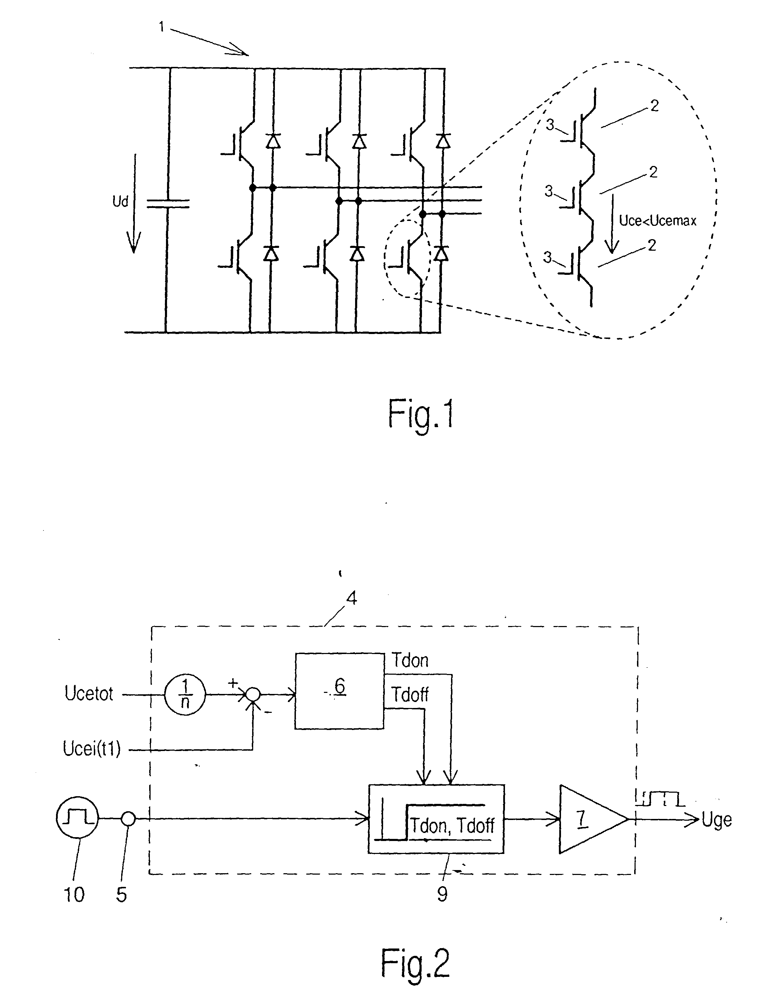

Zur Erhöhung der schaltbaren Spannung können schnelle Halbleiterschalter (2), z.B. wie der Insulated-Gate-Bipolar-Transistor IGBT, in Serie geschaltet werden (**Figur 1**). Bei den transienten Schaltvorgängen (Ein- und Ausschalten) und im stationär gesperrten Zustand (ausgeschaltet) verteilt sich die gesamte Spannungsbeanspruchung (Uce) aufgrund natürlicher Parameter-Unterschiede ungleichmässig auf die einzelnen Halbleiter (2).

Dies kann zur Überbeanspruchung einzelner Halbleiter führen.

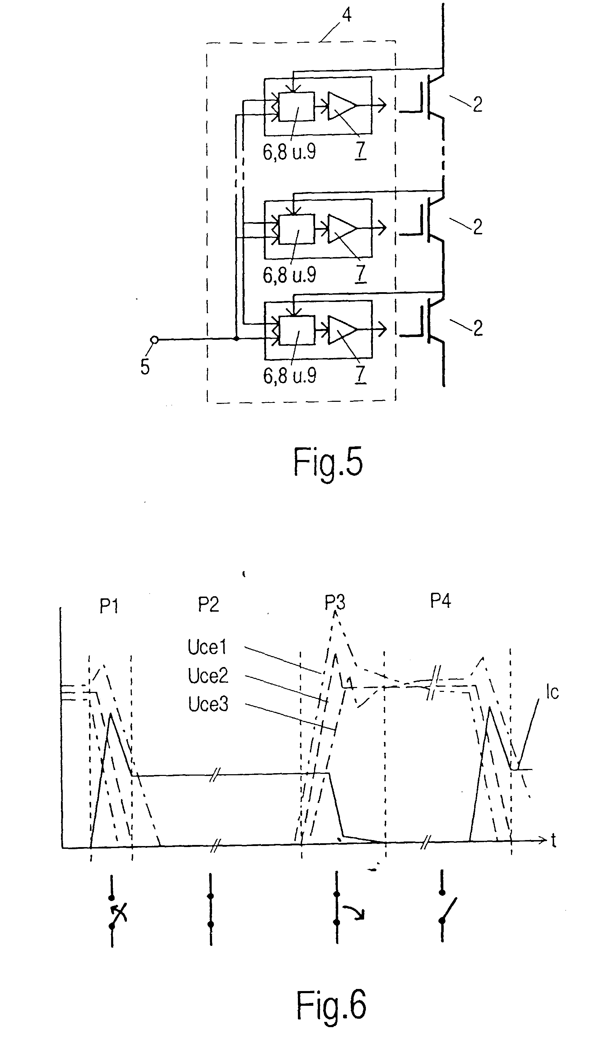

In **Figur 6** sind beispielhaft die unterschiedlichen Spannungen (Uce1, Uce2, Uce3) an drei Schaltern während der Phasen Einschalten (P1), Leiten (P2), Ausschalten (P3) und Sperren (P4) dargestellt.

Transient, d.h. während dem Ein- bzw. Ausschalten (Phasen P1 und P3) bestimmen vor allem halbleitereigene Eigenschaften wie z.B. Unterschiede bezüglich Speicherladung und Sperrschichtkapazität, unterschiedliche Verzögerungen und Ein- bzw. Ausschaltzeiten die Spannungsverteilung. Aber auch Unterschiede in der Ansteuerung durch Toleranz, Jitter- und Drift-behaftete Signallaufzeiten sowie Eigenschaften im Lastkreis (Streuinduktivitäten, Streu- und Erdkapazitäten und zusätzlichen Beschaltungen) haben einen nicht zu vernachlässigenden Einfluss.

Im ausgeschalteten Zustand (P4) ist die Spannungsaufteilung nicht stabil, sondern vom vorhergehenden Ausschaltvorgang, dem abgeschalteten Strom und von der Grösse, Toleranz und Drift des Leckstroms Ices sowie von einer allfälligen Beschaltung abhängig. Die Leckströme führen nach einer von Sperrschicht- und Beschaltungskapazitäten abhängigen Zeit zu einer ungleichmässigen stationären Spannungsaufteilung, bei welcher im ungünstigsten Fall ein einzelner Schalter die gesamte Sperrspannung aufnehmen muss. Beim Stand der Technik wurde nun yersucht, diese ungleichmässige Belastung dadurch zu vermeiden, dass alle Halbleiterschalter exakt gleichzeitig abgeschaltet wurden. Dadurch ist aber noch nicht unbedingt gewährleistet, dass die Spannungsverteilung auf die Schalter ausgeglichen ist, denn die Einflüsse von Parameter-Unterschieden werden mit dieser Regelung nicht berücksichtigt.

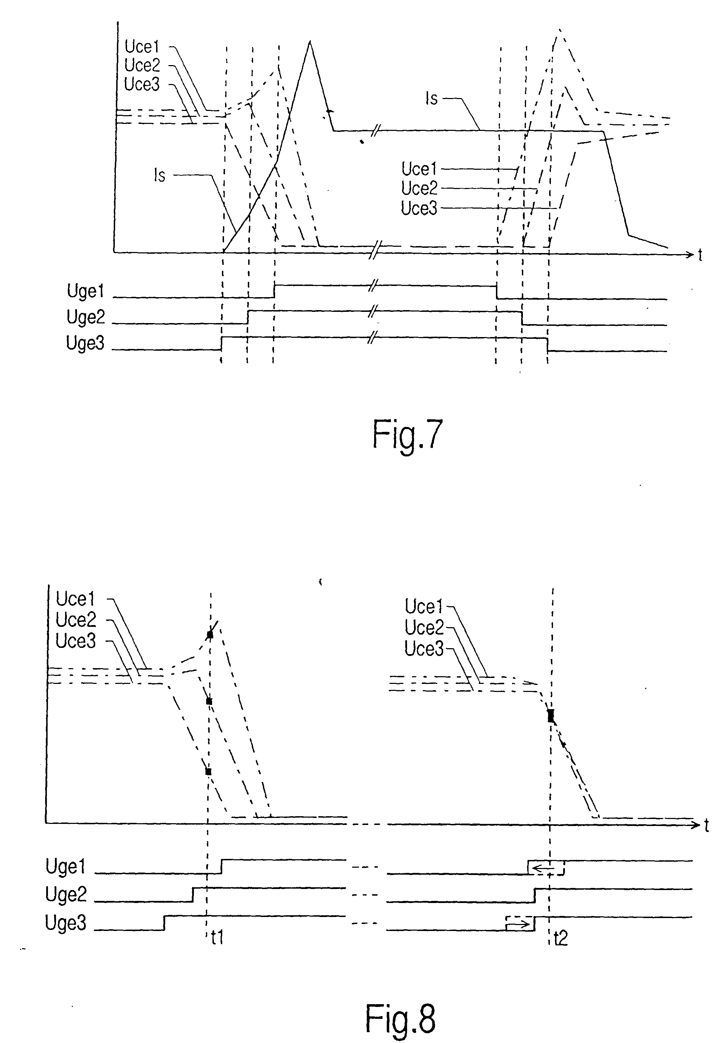

Nach der Erfindung wird nun ein anderer Weg beschritten. Wie **Figur 2** für das Ein- bzw. Ausschalten zeigt, wird an jedem der n, n≧2, Schalter (2) einer Serieschaltung eine Spannung (Uce1, Uce2 ... Ucei ... Ucen) gemessen. Anhand der gemessenen Spannung werden nun die Schaltzeitpunkte (Tdon, Tdoff) der Steuersignale (Uge1 ... Ugen) so bestimmt, dass die spannungsmässige Belastung beim Schalten für alle Schalter (2) im wesentlichen gleich gross wird. Aus **Figur 7** wird deutlich, dass beim Einschalten durch eine Verzögerung des Einschaltpunkts (z.B. Uge1) eine höhere Spannungsbelastung (Uce1) resultiert. Durch ein früheres Einschalten (z.B. Uge3) erhält man eine kleinere Spannungsbelastung (Uce3). Beim Ausschalten verhält es sich genau umgekehrt: früheres Ausschalten (Uge1) ergibt eine grössere Spannungsbelastung (Uce1), späteres (Uge3) eine kleinere (Uce3).

Die Regelung erfolgt nun so, dass in einer bestimmten Schaltphase (P1 oder P3) eine Differenz (1/nUcetot - Ucei) zwischen dem n-ten Teil der gesamten über der Serieschaltung anliegenden Spannung (Ucetot) und der gemessenen Spannung (Uce1 ... Ucen) gebildet wird. Ist die Differenz beim Einschalten positiv, d.h. die Spannung über dem bestimmten Schalter zu klein, so wird der betreffende Schalter beim nächsten Einschaltvorgang um einer gewisse Zeit später eingeschaltet. Ist die Differenz negativ wird um eine gewisse Zeit früher eingeschaltet. Die Zeitverschiebung wird für jeden Einschaltvorgang neu berechnet, so dass schlussendlich eine gleiche Spannungsverteilung resultiert. Wie **Figur 8** deutlich zeigt, heisst das aber noch nicht, dass damit alle Schalter zum gleichen Zeitpunkt eingeschaltet werden. Vielmehr werden sie zu dem Zeitpunkt eingeschaltet, in welchem für alle Schalter eine Spannungsgleichverteilung resultiert.

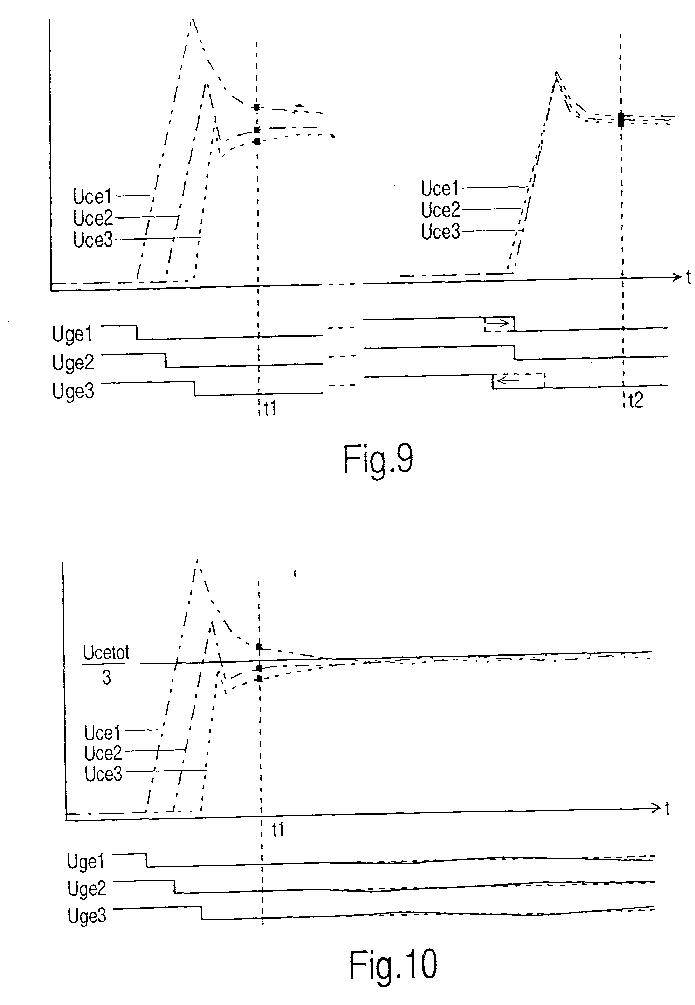

Beim Ausschalten wird analog vorgegangen (**Figur 9**), ausser, dass bei einer negativen Differenz (Spannung zu gross) beim nächsten Ausschalten später (z.B. Uge1), bei einer positiven Differenz früher (z.B. Uge3) ausgeschaltet wird. Auch hier gilt, dass nicht unbedingt gleichzeitig ausgeschaltet wird, sondern zu denjenigen Zeitpunkten, in welchen die Spannungsverteilung gleich ist.

Bei der Regelung handelt es sich um eine abgetastete Regelung, d.h. Spannungserfassung während eines bestimmten Schaltvorgangs (z.B. t1), Stelleingriff erst ein Schaltvorgang später (z.B. t2). Dadurch können Parameterschwankungen während des Betriebs adaptiv ausgeglichen werden. Zudem hat man zwischen zwei Schaltvorgängen genügend Zeit, die notwendigen Operationen durchzuführen.

Im stationären Zustand (Sperren, P4) wird nun eine andere Stellgrösse verwendet. Hier müssen die natürlicherweise verschiedenen und Drift-behafteten Leckströme der einzelnen Schalter sowie die Einflüsse von deren Beschaltungen so aufeinander abgeglichen werden, dass sich eine symmetrische Spannungsverteilung ergibt.

IGBTs und MOSFETs verhalten sich ungesättigt stationär wie spannungsgesteuerte Stromquellen. Dadurch kann der Sperrstrom mittels, einer Abschalt-Steuerspannung nahe an der Schwellspannung des Halbleiters gezielt vergrössert werden. Durch eine Vergrösserung des Sperrstroms nimmt die Spannung des einzelnen Halbleiters in der Serieschaltung ab. Damit kann durch Beeinflussung der Höhe der Abschalt-Steuerspannung (Ugeoff1,n) für jeden Schalter die Sperrspannung kontinuierlich ausgeregelt werden.

Zu diesem Zweck wird die Differenz zwischen dem n-ten Teil der total über der Serieschaltung anliegenden Spannung (Ucetot) und der gemessenen Spannung über dem Schalter (Uce1,n) gebildet. Nach Massgabe dieser Differenz wird nun die Höhe der Abschalt-Steuerspannungen (Ugeoff1,n) so bestimmt, dass eine ausgeglichene Spannungsverteilung resultiert (**Figur 10**). Die Messung der Schalterspannungen (Uce1,n) und die Differenzbildung kann entweder kontinuierlich oder (wie beim Ein-/Ausschalten) zeitdiskret erfolgen.

Da das System bei der Anwendung der stationären und transienten Ausgleichsregelung auf alle Einzelschalter regelungstechnisch überbestimmt ist und es dadurch unter Umständen zu einem Davonlaufen der Schaltzeitpunkte bzw. des Sperrstroms kommen könnte, ist es sinnvoll, einen der Schalter als Master und alle anderen als Slave zu behandeln. Dabei arbeiten die Slaves mit den eben beschriebenen Ausgleichsprinzipien, während der Master mit vorgegebenen Werten für die Schaltzeitpunkte und den Sperrstrom betrieben wird. Eine adaptive Einstellung des Master-Sperrstromes erlaubt eine automatische Nachführung an Toleranzen und Drift.

Eine erfindungsgemässe Stromrichterschaltungsanordnung umfasst (**Figuren 1-3**) eine Serieschaltung von n, n≧2, Leistungshalbleiterschaltern, welche z.B. Teil einer mehrphasigen Halbbrücke sein können. Die Halbleiterschalter können auf bekannte Art und Weise durch eine am Gate (3) angelegte Steuerspannung (Uge1 ... Ugen) zu beliebigen Zeitpunkten wiederholt ein- und ausgeschaltet werden. Zu diesem Zeck ist eine Ansteuereinheit (4) vorgesehen, welche mit den Gates in Verbindung steht und eine Steuersignaleingang (5) und einen Treiber (7) aufweist.

Um die oben erläuterte Regelung durchführen zu können, wird in der Ansteuereinheit die Spannung (Uce1 ... Ucen) über den einzelnen Schaltern sowie die Spannung (Ucetot) über der gesamten Serieschaltung messen. Aus diesen beiden Spannung (Ucei, Ucetot) wird je eine Differenz (1/nUcetot - Ucei) gebildet und an erste Mittel (6) weitergegeben,in welchen die Schaltzeitpunkte (Tdon, Tdoff) für jeden Schalter wie oben dargelegt bestimmt werden. Die ersten Mittel (6) sind weiter mit einer verzögerungsschaltung (9) verbunden, in welcher die Schaltzeitpunkte des Steuersignals eingestellt werden. Der Ausgang der Verzögerungsschaltung steht mit dem Treiber (7) in Verbindung, welcher seinerseits das Gate (3) der Schalter mit der Steuerspannung (Ugei) beaufschlagt.

Mittels der ersten Mittel (6) und der Verzögerungsschaltung (9) können also die Steuersignale (Uge1 .. Ugen) derart beeinflusst werden, dass beim Schalten eine ausgeglichene Spannungsverteilung resultiert.

In der Ansteuereinheit (4) sind zudem zweite Mittel (8) vorgesehen, welche anhand der berechneten Differenz die Höhe der Steuerspannung (Ugeoff1,n) im sperrenden Zustand (P4) laufend so einstellt, dass jeder Schalter spannungsmässig im wesentlichen gleich belastet wird. Diese zweiten Mittel sind mit dem Treiber (7) verbunden.

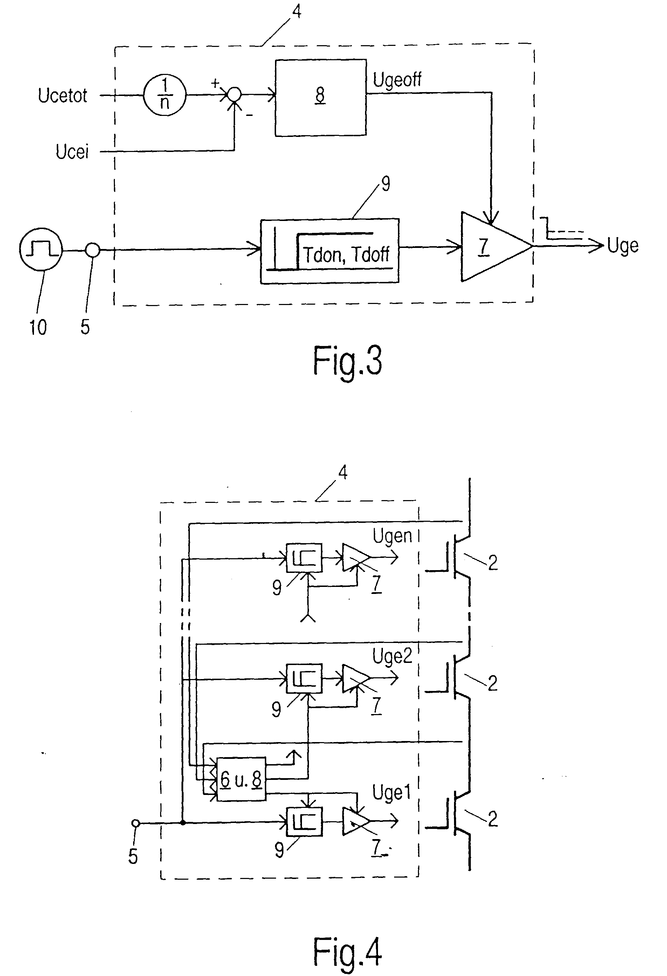

In den **Figuren 4 und 5** sind zwei bevorzugte Ausführungsbeispiel der erfindungsgemässen Schaltungsanordnung wiedergegeben. In der Ansteuereinheit (4) können für jeden Schalter lokal erste und zweite Mittel (6 und 8) vorgesehen werden (Figur 5.) Eine andere Variante besteht darin, dass die ersten und zweiten Mittel (6 und 8) zentral nur einmal vorgesehen sind und alle Treiber (7) und Verzögerungsschaltungen (9) von diesen zentralen ersten und zweiten Mittel (6 und 8) angesteuert werden (Figur 4).

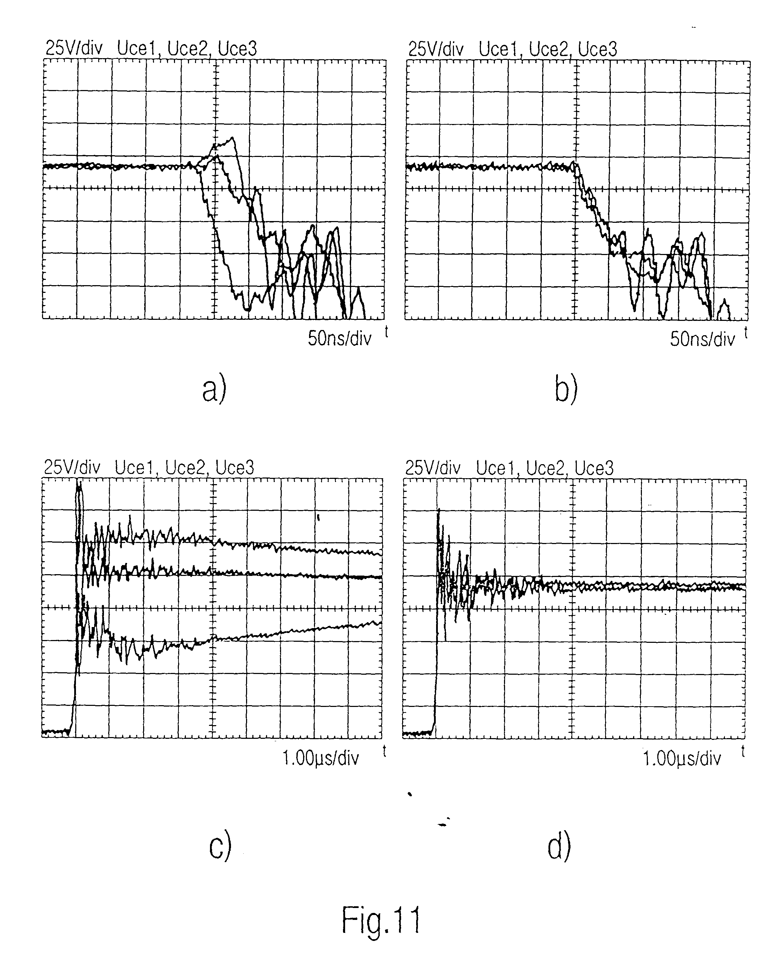

In den **Figuren 11a-d** sind Messergebnisse der Spannungen an drei Schaltern beim Einschalten (Figuren 11a und 11b) sowie beim Ausschalten (Figuren 11c und 11d) wiedergegeben. Wie man erkennt, ist die Spannungsverteilung beim Schalten mit Regelung (Figuren 11b und 11d) deutlich besser.

### Bezeichnungsliste

- 1: Stromrichterschaltungsanordnung
- 2: Leistungshalbleiterschalter
- 3: Gate
- 4: Ansteuereinheit
- 5: Steuersignaleingang
- 6: erste Mittel
- 7: Treiber
- 8: zweite Mittel
- 9: Verzögerungsschaltung
- 10: Steuersignalquelle
- P1: Einschalten
- P2: Leiten
- P3: Ausschalten
- P4: Sperren
- Uge1,n: Steuerspannungen für die Schalter 1-n
- Ugeoff1,n: Steuerspannungen im gesperrten Zustand
- Uce1,n: Spannungen über den Schaltern 1-n
- Ucetot tot.: Spannung über Serieschaltung der Schalter
- Tdon: Einschaltzeitpunkt
- Tdoff: Ausschaltzeitpunkt

## Patentansprüche

1. Verfahren zur Ansteuerung einer Stromrichterschaltungsanordnung (1),
a) welche Schaltungsanordnung (1) n in Serie geschaltete Leistungshalbleiterschalter (2) umfasst, wobei die Leistungshalbleiterschalter (2) je über eine an einem Gate (3) angelegte Steuerspannung (Uge1, Ugen) zu beliebigen Ein- bzw. Ausschaltzeitpunkten (Tdon, Tdoff) wiederholt ein- bzw. ausschaltet werden und somit die Zustände Leiten (P2) und Sperren (P4) annehmen können,
b) bei welchem Verfahren eine spannungsmässige Belastung der einzelnen Leistungshalbleiterschalter (2) beim Ausschalten (P3) durch eine Regelung der Abschaltzeitpunkte (Tdoff) der einzelnen Leistungshalbleiterschalter (2) ausgeglichen wird,
dadurch gekennzeichnet, dass
c) als Regelgrösse über jedem Schalter (2) eine Schalterspannung (Uce1) gemessen wird,
d) anhand der gemessenen Spannungen (Uce1) die Schaltzeitpunkte (Tdon, Tdoff) der Schalter (2) so bestimmt werden, dass die spannungsmässige Belastung beim Schalten für alle Schalter (2) im wesentlichen ausgeglichen wird, und
e) anhand der gemessenen Spannungen (Uce1). für jeden Schalter (2) die Höhe der Steuerspannung beim Sperren derart berechnet wird, dass die spannungsmässige Belastung der einzelnen Schalter (2) beim Sperren (P4) im wesentlichen gleich gross wird.

2. Verfahren nach Anspruch 1, dadurch gekennzeichnet, dass
a) für einen bestimmten Schaltzeitpunkt während dem Einschalten bzw. Ausschalten (P1, P3) je eine Differenz aus dem n-ten Teil einer totalen, über der Serieschaltung anliegenden Spannung (Ucetot) und den gemessenen Spannungen (Uce1) berechnet wird;
b) in der Zeit zwischen zwei Schaltvorgängen aus den berechneten Differenzen die Ein- bzw. Ausschaltzeitpunkte (Tdon, Tdoff) der Steuersignale (Uge1, Ugen) jedes einzelnen Schalters (2) bestimmt werden; und
c) die Schalter im (2) nächsten Schaltzeitpunkt mittels der berechneten Steuersignale (Uge1, Ugen) angesteuert werden.

3. Verfahren nach Anspruch 2, dadurch gekennzeichnet, dass
a) beim Einschalten (P1) zu einem späteren Einschaltzeitpunkt (Tdon) eingeschaltet wird, falls die berechnete Differenz positiv ist bzw. zu einem früheren, falls die berechnete Differenz negativ ist, und
b) beim Ausschalten (P3) zu einem späteren Ausschaltzeitpunkt (Tdoff) ausgeschaltet wird, falls die Differenz negativ ist bzw. zu einem früheren, falls die berechnete Differenz positiv ist.

4. Verfahren nach Anspruch 1, dadurch gekennzeichnet, dass beim Sperren (P4)
a) je eine Differenz aus dem n-ten Teil einer totalen, über der Serieschaltung anliegenden Spannung (Ucetot) und den gemessen Spannungen (Uce1) gebildet wird;
b) aus diesen Differenzen für jeden Schalter (2) die Höhe der Steuerspannungen berechnet wird.

5. Verfahren nach Anspruch 4, dadurch gekennzeichnet, dass die Spannungen (Uge1, Ugen) erhöht werden, falls die Differenz positiv ist bzw. erniedrigt, falls die Differenz negativ ist.

6. Verfahren nach einem der Ansprüche 1, 2 oder 3 dadurch gekennzeichnet, dass ein bestimmter Schalter als Master mit vorgegebenen Werten für Ein- und Ausschaltzeit (Tdon, Tdoff) sowie Höhe der Sperrsteuerspannung (Ugeoff) betrieben wird, während die Werte (Tdon, Tdoff, Ugeoff) der übrigen Schalter (2) wie in den Ansprüchen 2 und 3 bestimmt werden.

7. Stromrichterschaltungsanordnung, umfassend
a) eine Serieschaltung von n, Leistungshalbleiterschaltern (2), welche über eine an einem Gate (3) angelegte Steuerspannung (Uge1, Ugen) zu beliebigen, sich wiederholenden Zeitpunkten (Tdon, Tdoff) ein- bzw. ausgeschaltet werden und damit die Zustände Leiten (P2) und Sperren (P4) annehmen können; und
b) eine Ansteuereinheit (4) mit einem Steuersignaleingang (5), an welchen eine Steuersignalquelle (10) angeschlossen werden kann und in welcher Ansteuereinheit (5) die Steuersignale (Uge1, Ugen) erzeugt werden, und einen Treiber (7), in welchem die Steuersignale (Uge1, Ugen) verstärkt werden;
dadurch gekennzeichnet, dass
c) in der Ansteuereinheit (4) erste Mittel (6) vorgesehen sind, welche über eine Verzögerungsschaltung (9) mit der Steuersignalquelle (10) verbunden sind;
d) in der Ansteuereinheit (4) eine Spannung (Uce1) über jedem Schalter (2) gemessen wird und eine Differenz aus dem n-ten Teils einer totalen, über der Serieschaltung der n Leistungshalbleiterschalter gemessenen Spannung (Ucetot) und den gemessenen Spannungen (Uce1) gebildet wird, wobei
e) die ersten Mittel (6) die Ein- bzw. Ausschaltzeiten (Tdon, Tdoff) der Steuersignale (Uge1, Ugen) der einzelnen Schalter (2) in der Verzögerungsschaltung (9) derart regeln, dass alle Schalter (2) beim Ein- und Ausschalten spannungsmässig im wesentlichen gleich belastet sind;
d) in der Ansteuereinheit (4) zweite Mittel (8) vorgesehen sind, welche mit dem Treiber (7) verbunden sind und welche beim Sperren (P4) dauernd anhand der berechneten Differenz die Höhe der Steuerspannungen im sperrenden Zustand so einstellen, dass die spannungsmässige Belastung der einzelnen Schalter beim Sperren im wesentlichen gleich gross ist.

8. Schaltungsanordnung nach Anspruch 7, dadurch gekennzeichnet, dass die Messung der Schalterspannung (Uce1) , die Differenzbildung und die Berechnung der Ein-/Ausschaltzeitpunkte (tdon, tdoff) beim Ein- und Ausschalten (P1, P2) einen entsprechenden Zustand früher erfolgen als deren Beaufschlagung.

9. Schaltungsanordnung nach Anspruch 8, dadurch gekennzeichnet, dass die Ansteuereinheit (4) für alle Schalter (2) zentral erste und zweite Mittel (6, 8) aufweist, und jedem Schalter (2) dezentral ein Treiber (7) und eine Verzögerungsschaltung (9) zugeordnet ist.

10. Schaltungsanordnung nach Anspruch 9, dadurch gekennzeichnet, dass in der Ansteuereinheit (4) für jeden Schalter (2) dezentral ein Treiber (7), eine Verzögerungsschaltung (9) sowie erste und zweite Mittel (6, 8) vorgesehen sind.

11. Schaltungsanordnung nach eine der Ansprüche 7-10, dadurch gekennzeichnet, dass es sich bei den Leistungshalbleiterschaltern um MOS gesteuerte Schalter, insbesondere um MOSFETs oder IGBTs handelt.

## Claims

1. Method for driving an electronic power converter circuit arrangement (1),
a) which circuit arrangement (1) comprises n series-connected power semiconductor switches (2), the power semiconductor switches (2) each being repeatedly turned on and off via a control voltage (Uge1, Ugen), applied to a gate (3), at arbitrary turn-on and turn-off instants (Tdon, Tdoff) and thus being able to assume the states of "conduction" (P2) and "blocking" (P4),
b) in which method a voltage loading of the individual power semiconductor switches (2) is balanced during turn-off (P3) by controlling the turn-off instants (Tdoff) of the individual power semiconductor switches (2),
characterized in that
c) a switch voltage (Uce1) is measured across each switch (2) as controlled variable,
d) the switching instants (Tdon, Tdoff) of the switches (2) are determined with the aid of the measured voltages (Uce1) in such a way that the voltage loading is essentially balanced for all
the switches (2) during switching, and e) the level of the control voltage during blocking is calculated for each switch (2) with the aid of the measured voltages (Uce1) in such a way that the voltage loading of the individual switches (2) becomes essentially equal during blocking (P4).

2. Method according to Claim 1, characterized in that
a) for a specific switching instant during turn-on or turn-off (P1, P3) a difference is respectively calculated from the nth part of a total voltage (Ucetot) applied across the series circuit and the measured voltages (Uce1);
b) in the time between two switching operations, the turn-on or turn-off instants (Tdon, Tdoff) of the control signals (Uge1; Ugen) of each individual switch (2) are determined from the calculated differences; and
c) the switches are driven at the (2) next switching instant by means of the calculated control signals (Uge1, Ugen).

3. Method according to Claim 2, characterized in that
a) in the case of turn-on (P1), turn-on is made at a later turn-on instant (Tdon) if the calculated difference is positive, and at an earlier one if the calculated difference is negative, and
b) in the case of turn-off (P3), turn-off is made at a later turn-off instant (Tdoff) if the difference is negative, and at an earlier one if the calculated difference is positive.

4. Method according to Claim 1, characterized in that during blocking (P4)
a) a difference is respectively formed from the nth part of a total voltage (Ucetot) applied across the series circuit and the measured voltages (Uce1);
b) the level of the control voltages is calculated from these differences for each switch (2).

5. Method according to Claim 4, characterized in that the voltages (Uge1, Ugen) are increased if the difference is positive and decreased if the difference is negative.

6. Method according to one of Claims 1, 2 or 3, characterized in that a specific switch is operated as master with prescribed values for turn-on and turn-off time [sic] (Tdon, Tdoff) as well as the level of the blocking control voltage (Ugeoff), while the values (Tdon, Tdoff, Ugeoff) of the remaining switches (2) are determined as in Claims 2 and 3.

7. Electronic power converter circuit arrangement comprising
a) a series circuit of n, power semiconductor switches (2) which are turned on or off at arbitrary, repeating instants (Tdon, Tdoff) via a control voltage (Uge1, Ugen) applied to a gate (3), and can thus assume the states of "conduction" (P2) and "blocking" (P4); and
b) a drive unit (4) having a control signal input (5) to which a control signal source (10) can be connected, and in which drive unit (5) the control signals (Uge1, Ugen) are generated, and a driver (7) in which the control signals (Uge1, Ugen) are amplified;
characterized in that
c) first means (6) are provided in the drive unit (4) which are connected to the control signal source (10) via a time-delay circuit (9);
d) in the drive unit (4), a voltage (Uce1) is measured across each switch (2) and a difference is formed from the nth part of a total voltage (Ucetot) measured across the series circuit of the n power semiconductor switches and the measured voltages (Uce1), it being the case that
e) the first means (6) control the turn-on and turn-off times [sic] (Tdon, Tdoff) of the control signals (Uge1, Ugen) of the individual switches (2) in the time-delay circuit (9) in such a way that all the switches (2) are essentially equally loaded in terms of voltage during turn-on and turn-off;
d) second means (8) are provided in the drive unit (4) which are connected to the driver (7) and which during blocking (P4) permanently set the level of the control voltages in the blocking state with the aid of the calculated difference in such a way that the voltage loading of the individual switches is essentially equal during blocking.

8. Circuit arrangement according to Claim 7, characterized in that during turn-on and turn-off (P1, P2) the measurement of the switch voltage (Uce1), the subtraction and the calculation of the turn-on/turn-off instants (tdon, tdoff) are performed a corresponding state earlier than their application.

9. Circuit arrangement according to Claim 8, characterized in that the drive unit (4) has central first and second means (6, 8) for all the switches (2), and each switch (2) is decentrally assigned a driver (7) and a time-delay circuit (9).

10. Circuit arrangement according to Claim 9, characterized in that a driver (7), a time-delay circuit (9) and first and second means (6, 8) are provided decentrally in the drive unit (4) for each switch (2).

11. Circuit arrangement according to one of Claims 7-10, characterized in that the power semiconductor switches are MOS-controlled switches, in particular MOSFETs or IGBTs.

## Revendications

1. Procédé de commande d'un montage de circuit convertisseur de courant (1),
a) lequel montage de circuit (1) comprend n commutateurs de puissance à semi-conducteurs (2) montés en série, les commutateurs de puissance à semi-conducteurs (2) pouvant être enclenchés et déclenchés à plusieurs reprises à des moments d'enclenchement et de déclenchement (Tdon, Tdoff) quelconques à l'intervention d'une tension de commande (Uge1, Ugen) appliquée à une électrode de commande (3) et pouvant ainsi occuper les états "passant" (P2) et "bloqué" (P4),
b) dans lequel une contrainte en tension des différents commutateurs de puissance à semi-conducteurs (2) est compensée, lors du déclenchement (P3), par une régulation des moments de coupure (Tdoff) des différents commutateurs de puissance à semi-conducteurs (2),
caractérisé en ce que
c) une tension appliquée aux commutateurs (Uce1) est mesurée en tant que grandeur de régulation à chaque commutateur (2),
d) sur la base des tensions mesurées (Uce1), les moments de commutation (Tdon, Tdoff) des commutateurs (2) sont déterminés de manière à pratiquement compenser la contrainte en tension pour tous les commutateurs (2) lors de la commutation, et
e) sur la base des tensions mesurées (Uce1), la grandeur de la tension de commande (Ugenoff) est calculée à l'état bloqué pour chaque commutateur (2), de telle sorte que la contrainte en tension des différents commutateurs (2) soit pratiquement identique à l'état bloqué (P4).

2. Procédé suivant la revendication 1, caractérisé en ce que
a) pour un moment de commutation déterminé au cours de l'enclenchement et du déclenchement (P1, P3), une différence est chaque fois formée à partir de la énième fraction d'une tension totale (Ucetot) présente sur le montage en série et des tensions mesurées (Uce1);
b) pendant le temps séparant deux opérations de commutation sont déterminés, à partir des différences calculées, les moments d'enclenchement et de déclenchement (Tdon, Tdoff) des signaux de commande (Uge1, Ugen) de chacun des commutateurs (2), et en ce que
c) les commutateurs (2) sont commandés, lors du moment de commutation suivant, au moyen des signaux de commande calculés (Uge1, Ugen).

3. Procédé suivant la revendication 2, caractérisé en ce que
a) lors de l'enclenchement (P1), l'enclenchement a lieu à un moment d'enclenchement ultérieur (Tdon) si la différence calculée est positive et à un moment d'enclenchement antérieur si la différence calculée est négative, et
b) lors du déclenchement (P3), le déclenchement a lieu à un moment de déclenchement ultérieur (Tdoff) si la différence calculée est négative et à un moment de déclenchement antérieur si la différence calculée est positive.

4. Procédé suivant la revendication 1, caractérisé en ce qu'à l'état bloqué (P4)
a) une différence est chaque fois formée à partir de la énième fraction d'une tension totale (Ucetot) présente sur le montage en série, et des tensions mesurées (Uce1) ;
b) la grandeur des tensions de commande (Ugenoff) est calculée pour chaque commutateur (2) à partir de ces différences.

5. Procédé suivant la revendication 4, caractérisé en ce que les tensions (Uge1, Ugen) sont augmentées si la différence est positive et sont diminuées si la différence est négative.

6. Procédé suivant l'une ou l'autre des revendications 1, 2 et 3, caractérisé en ce qu'un commutateur déterminé fonctionne en tant que maître avec des valeurs prédéterminées pour les moments d'enclenchement et de déclenchement (Tdon, Tdoff) ainsi que pour la grandeur de la tension de commande de blocage (Ugeoff), alors que les valeurs (Tdon, Tdoff, Ugeoff) des autres commutateurs (2) sont déterminées comme dans les revendications 2 et 3.

7. Montage de circuit convertisseur de courant, comprenant
a) un montage en série de n commutateurs de puissance à semi-conducteurs (2), pouvant être enclenchés et déclenchés à l'intervention d'une tension de commande (Uge1, Ugen) appliquée à une électrode de commande (3) à des moments quelconques (Tdon, Tdoff) répétitifs et pouvant ainsi occuper les états passant (P2) et bloqué (P4); et
b) une unité de commande (4), pourvue d'une entrée de signal de commande (5) à laquelle une source de signal de commande (10) peut être connectée et dans laquelle sont générés les signaux de commande (Uge1, Ugen), et un étage d'attaque (7), dans lequel les signaux de commande (Uge1, Ugen) sont amplifiés;
caractérisé en ce que
c) dans l'unité de commande (4) sont prévus des premiers moyens (6), qui sont reliés à la source de signal de commande (10) par l'intermédiaire d'un circuit à retard (9);
d) dans l'unité de commande (4), une tension (Uce1) est mesurée aux bornes de chaque commutateur (2) et une différence est formée à partir de la énième fraction d'une tension totale (Ucetot) mesurée sur le montage en série des n commutateurs de puissance à semi-conducteurs, et des tensions mesurées (Uce1), étant entendu que
e) les premiers moyens (6) règlent les moments d'enclenchement et de déclenchement (Tdon, Tdoff) des signaux de commande (Uge1, Ugen) des différents commutateurs (2) dans le circuit à retard (9) de telle sorte que tous les commutateurs (2) présentent une contrainte en tension pratiquement égale lors de l'enclenchement et du déclenchement;
f) dans l'unité de commande (4) sont prévus des seconds moyens (8) qui sont reliés à l'étage d'attaque (7) et qui, lors du blocage (P4), règlent en permanence la grandeur des tensions de commande à l'état bloqué à l'aide de la différence calculée, de telle sorte que les contraintes en tension des différents commutateurs soient pratiquement égales lors du blocage.

8. Montage de circuit suivant la revendication 7, caractérisé en ce que la mesure de la tension aux bornes des commutateurs (Uce1), la formation de la différence et le calcul des moments d'enclenchement/déclenchement (Tdon, Tdoff) lors de l'enclenchement et du déclenchement (P1, P2) ont lieu au cours d'un état correspondant précédant l'alimentation des commutateurs.

9. Montage de circuit suivant la revendication 8, caractérisé en ce que l'unité de commande (4) présente pour tous les commutateurs (2) des premiers et seconds moyens centraux (6, 8) et en ce qu'à chaque commutateur (2) sont associés de manière décentralisée un étage d'attaque (7) et un circuit à retard (9).

10. Montage de circuit suivant la revendication 9, caractérisé en ce que dans l'unité de commande (4) sont prévus de manière décentralisée pour chaque commutateur (2) un étage d'attaque (7), un circuit à retard (9) ainsi que des premiers et seconds moyens (6, 8).

11. Montage de circuit suivant l'une quelconque des revendications 7 à 10, caractérisé en ce que les commutateurs de puissance à semi-conducteurs sont des commutateurs commandés MOS, en particulier des transistors MOSFET et IGBT.
